# EUROPEAN PATENT APPLICATION

(11) **EP 4 811 960 A2**
(43) Date of publication of application: **23.09.2026**
(21) Application number: 26166088.0
(22) Date of filing: 19.03.2026
(51) Int. Cl.: H10D 62/10, H10D 64/00, H10D 12/00, H10D 12/01, H10D 8/00, H10D 30/66

(54) **A SEMICONDUCTOR DEVICE WITH A TERMINATION REGION AND A PASSIVATION LAYER, AND A MANUFACTURING METHOD FOR THE SEMICONDUCTOR DEVICE**

(30) Priority: 19.03.2025 CN 202510326903
(71) Applicant: SwissSEM Technologies AG, 5600 Lenzburg (CH); Sun.King Pacific Semiconductors Technology (Zhejiang) Co.,Ltd, Jiaxing City, Zhengjiang 314100 (CN)
(72) Inventor: SCHNEIDER, Nick, 5600 Lenzburg (CH); REIGOSA DIAZ, Paula, 5600 Lenzburg (CH); STECCONI, Tommaso, 5600 Lenzburg (CH); KNOLL, Lars, 5600 Lenzburg (CH)
(74) Representative: Kuhnen & Wacker Patent- und Rechtsanwaltsbüro PartG mbB

(57) **Abstract**

A semiconductor device having a termination region and a passivation structure is disclosed. The device comprises a substrate (1) with an upper end face and a lower end face, the upper end face including a drift region (2) of a first conductivity type. A plurality of protective rings (3) of a second conductivity type are formed in the upper end face and extend into the drift region (2). A first insulating film (4) is arranged on the upper end face, separating adjacent protective rings (3), wherein an upper end face of each protective ring is lower than an upper end face of the first insulating film (4). A second insulating film (5) is disposed on the first insulating film (4) and the protective rings (3) and includes a plurality of through holes (51) corresponding to the protective rings (3), each through hole (51)having an inner wall forming an acute angle with the upper end face of the substrate (1). A metal layer (6) is arranged within each through hole (51), wherein an upper end surface of each metal layer (6) is lower than an upper end surface of the second insulating film (5). A first passivation layer (7) is arranged on the second insulating film (5) and the metal layer (6), and a second passivation layer (8) is arranged on the first passivation layer (7). The configuration improves electric field distribution and enhances device reliability.

## Description

### TECHNICAL FIELD

The present invention relates to the field of semiconductor technology, particularly to a semiconductor device with a termination region and a passivation layer and to a method for manufacturing such semiconductor device.

### BACKGROUND

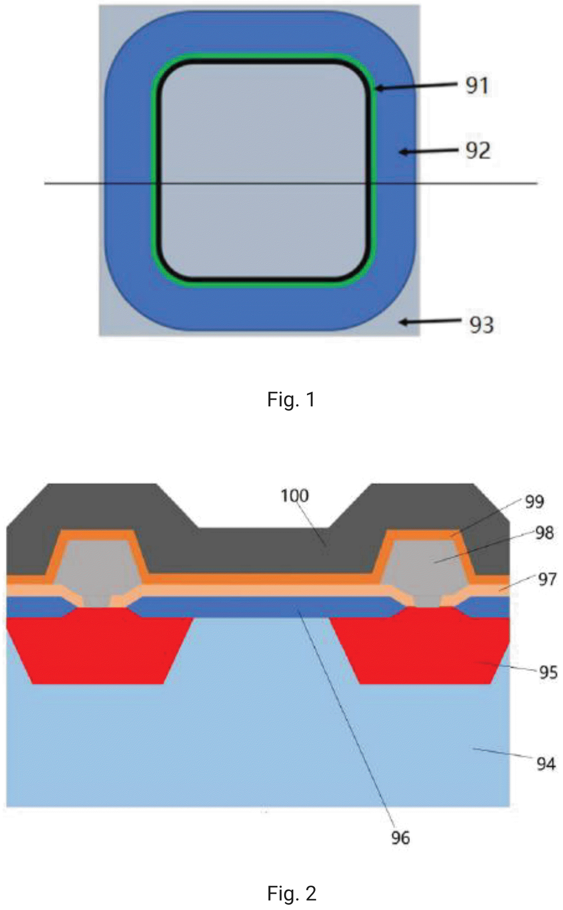

Vertical power semiconductor devices, such as metal oxide semiconductor field-effect transistors (MOSFETs), insulated gate bipolar transistors (IGBTs), or FRDs (fast recovery diodes), include an active region and a termination region surrounding the active region, which can electrically isolate and protect the device from high voltage effects. There may also be some transition regions between the active region and the termination region. The presence of high electric fields cab accelerate chemical breakdown lead to premature device failure. Therefore, as shown in Figure 1, a vertical power semiconductor device includes a chip 93, on which there are a transition region 91 and a termination region (termination area) 92. A passivation layer is usually used to cover the termination area, so that moisture or other corrosive substances in the environment cannot reach the termination area. The combination of the termination area and the passivation layer must also work within the entire required temperature range, usually from -40 °C to 150 °C. Therefore, suitable materials, structures, deposition, and etching processes need to be selected.

A common structure includes multiple guard rings arranged around the active region (p-ring termination). Guard rings may be achieved through injection steps and diffusion, others through trench structures (trench termination), and still others through multiple overlapping impurity layers that result in gradually decrease step by step (LVD termination). At present, technological solutions tend to be more planar, LVD terminations requiring more silicon area to achieve the desired blocking rate and higher patterning density to achieve more compact design.

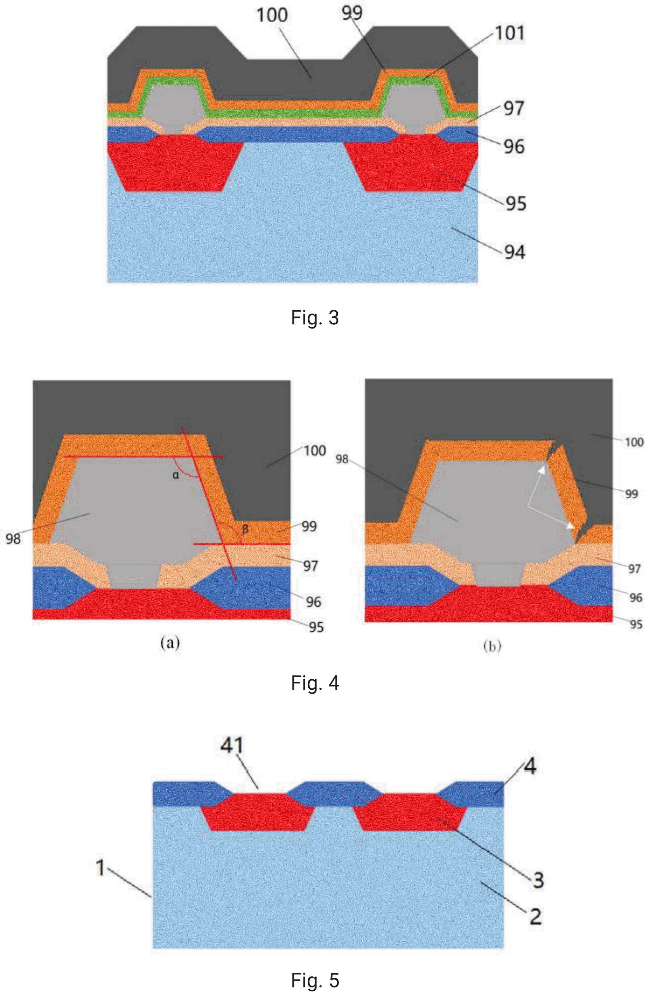

As shown in Figure 2, which is a cross-sectional view of the device shown in Figure 1, the vertical power semiconductor device comprises a substrate having a drift region 94 formed thereon, and a plurality of p-type guard rings 95 arranged at intervals on the substrate. On the substrate it is also formed a field oxide 96. The field oxide 96 is covered with a boron-phosphorus-silicate glass (BPSG) layer 97. A metal (AlCu) ring 98 contacts the field oxide 96, and the metal ring 98 is passivated by a silicon-rich nitride layer 99 and a polyimide film 100. In common power semiconductor devices the multiple guard rings are arranged around the active region, wherein the spacing between each guard ring is determined by the field-oxide structure. Field oxides can be formed through etching or selective growth, such as local oxidation of silicon (LOCOS). The guard rings are usually in contact with a metal field plate (metal ring), which is usually made of the same metal material as the top metallization layer and can be made of AlCu, AlSi, AlSiCu or similar materials. The metal rings are patterned through photolithography and subsequent etching at selected locations. In order to maintain a relatively small feature size, the etching angle must be sharp, and the thickness of the metal is usually a few micrometers, as the same layer is used to contact the device in the active region, for example, through wire bonding. The passivation layers conform to the contour of the lower layers, so they have the same acute angle as the metal below. As shown in Figure 3, another device similar to the device of Figure 2, includes a semi insulating layer 101 of amorphous silicon or similar material arranged between the passivation layers and the metal ring 98 to alleviate mechanical stress, but this requires additional processing steps and significantly increases the leakage current of the device. As shown in Figures a and b of Figure 4, which show a portion of Figure 2, the existing critical angle β may lead to cracking in the passivation layer. Figure a depicts the existing critical angle, while Figure b illustrates passivation cracking. Passivation layer cracking is one of the most common failure mechanisms in power semiconductor devices, as humidity and other pollutants can penetrate and reach highly corrosive metal structures, while high electric fields catalyze terminal damage.

### SUMMARY OF THE INVENTION

The object of the present invention is to provide a semiconductor device with a (edge) termination region and a passivation layer, and a manufacturing method for manufacturing such semiconductor device which can overcome at least some of the above indicated issues. The invention is set out in the appended claims.

Throughout the description and claims, an acute angle formed by an inner wall of a through-hole with the upper surface of the substrate shall mean the angle that the inner wall of the through-hole forms at the outside of the through-hole with the upper surface of the substrate. To determine this angle, an averaged upper end face of the substrate may be used, defined by the mean height level of the uneven upper end face. The semiconductor device with an edge termination region and a passivation layer according to the invention can overcome the technical problem of cracks easily occurring in the passivation layer above the metal layer of the existing structure, which can penetrate and corrode the metal layer due to humidity and other pollutants, and the existence of high electric fields to catalyze terminal damage can be solved.

In some embodiments, a semiconductor device is provided, comprising a termination region and a passivation layer, wherein the semiconductor device includes: a substrate, the substrate comprising an upper surface and a lower surface, the upper surface of the substrate being provided with a drift region of a first conductivity type; a first insulating film on the upper surface of the substrate; the upper surface of the substrate further comprises a plurality of second-type protective rings, each of which extends into the drift region; adjacent protective rings are separated by the first insulating film, and the upper surfaces of the protective rings are lower than the upper surface of the first insulating film; a second insulating film is provided on the first insulating film and the protective rings; the second insulating film is provided with second insulating film through-holes that correspond one-to-one with and communicate with each protective ring, and the inner walls of each second insulating film through-hole form an acute angle with the upper surface of the substrate; a metal layer is provided within each second insulating film through-hole, and the upper surface of the metal layer located within the second insulating film through-hole is lower than the upper surface of the second insulating film; a first passivation layer is provided on the second insulating film and the metal layer; A second passivation layer is provided on the first passivation layer.

Exemplarily, the acute angle is 30° or 70-80°; the thickness of the metal layer is 1-8 µm, and the thickness of the second insulating film is greater than that of the metal layer.

Exemplarily, the second insulating film is made of phosphosilicate glass.

Exemplarily, the first insulating film is made of silicon dioxide; the first passivation layer is made of silicon-rich nitride (SiNx); the second passivation layer is made of a polymer; the metal layer is made of Al, AlCu, or AlSiC; the substrate is a silicon wafer.

Exemplarily, the polymer is polyimide.

In some embodiments, a method for preparing a semiconductor device based on any of the above-mentioned devices having a termination region and a passivation layer, comprises the following steps: oxidizing the substrate, thermally growing and forming a first insulating film, etching the first insulating film to form a first etched trench communicating with the substrate, implanting boron ions into the first etched trench, and forming protective rings on the substrate, with the upper surfaces of each protective ring being lower than the upper surface of the first insulating film; depositing a second insulating film on the first insulating film and the protective rings; patterning and etching the second insulating film to form second insulating film through-holes on the second insulating film that are in one-to-one correspondence and communication with the respective protective rings, wherein the angle between the inner wall of each second insulating film through-hole and the upper surface of the substrate is an acute angle; a metal layer is deposited on the second insulating film and the second insulating film through-holes to form a metal layer. The metal layer is etched to expose the second insulating film, with the upper surface of the metal layer within the second insulating film through-holes lying below the upper surface of the second insulating film; a first passivation layer is deposited on the second insulating film and the metal layer; a second passivation layer is deposited on the first passivation layer, resulting in a semiconductor device having a termination region and passivation layers.

Exemplarily, the second insulating film, the first passivation layer, and the second passivation layer are all prepared using a PECVD deposition process.

In some embodiments, a semiconductor device having a termination region and a passivation layer, comprises: a substrate, the substrate comprising an upper surface and a lower surface, wherein the upper surface of the substrate is provided with a drift region of a first conductivity type; a first insulating film on the upper surface of the substrate; the upper surface of the substrate further comprises a plurality of second-type protective rings, each of which extends into the drift region, with adjacent protective rings separated by the first insulating film, and the upper surfaces of the protective rings lying below the upper surface of the first insulating film; an additional insulating film is provided on the first insulating film and the protective rings; a silicon nitride layer is provided on the additional insulating film; A second insulating film is provided on the silicon nitride layer; Grooves are provided on each protective ring; the second insulating film located above the protective rings is provided with second insulating film through-holes that correspond one-to-one with and communicate with the silicon nitride layer; the angle between the inner wall of the second insulating film through-hole and the upper surface of the substrate is an acute angle; the silicon nitride layer above the protective rings is provided with silicon nitride layer through-holes communicating with the additional insulating film, wherein the angle between the inner wall of the silicon nitride layer through-hole and the upper surface of the substrate is 30° or 70-80°; the additional insulating film located above the protective ring is provided with an additional insulating film through-hole communicating with the groove; the second insulating film through-hole, the silicon nitride layer through-hole, the additional insulating film through-hole, and the groove are coaxially arranged; the through-holes in the additional insulating film and the groove are filled with tungsten; a metal layer is provided within the through-holes of the silicon nitride layer and the through-holes of the second insulating film, and the upper surface of the metal layer is lower than the upper surface of the second insulating film; a first passivation layer is provided on the second insulating film, and a second passivation layer is provided on the first passivation layer.

Exemplarily, the acute angle is 30° or 70-80°; the thickness of the metal layer is 1-8 µm, and the thickness of the second insulating film is greater than that of the metal layer.

Exemplarily, the second insulating film is made of phosphosilicate glass.

Exemplarily, the additional insulating film is made of borosilicate glass.

Exemplarily, the upper surface of each protective ring has one or more grooves.

Exemplarily, the first insulating film is made of silicon dioxide; the first passivation layer is made of silicon-rich nitride (SiNx); the second passivation layer is made of a polymer; the metal layer is made of Al, AlCu, or AlSiCu; the polymer is polyimide.

In some embodiments, a method for preparing a semiconductor device based on any of the devices described above, having a termination region and passivation layers, comprises the following steps:
oxidizing the substrate; thermally growing a first insulating film; etching the first insulating film to form a first etched trench communicating with the substrate; implanting boron ions into the first etched trench;
forming protective rings on the substrate, with the upper surfaces of each protective ring lying below the upper surface of the first insulating film; and forming grooves on each protective ring; depositing an additional insulating film on the first insulating film and the protective rings; depositing a silicon nitride layer on the additional insulating film; depositing a second insulating film on the silicon nitride layer;
patterning the second insulating film and etching it to form second insulating film through-holes in the second insulating film above the protective rings, each through-hole corresponding one-to-one with the silicon nitride layer; the angle between the inner wall of each second insulating film through-hole and the upper surface of the substrate is acute; etching the silicon nitride layer beneath the second insulating film through-holes to form silicon nitride layer through-holes communicating with the additional insulating film; the angle between the inner wall of the silicon nitride layer through-hole and the upper surface of the substrate is the same as the angle between the inner wall of the second insulating film through-hole and the upper surface of the substrate; etching the additional insulating film from within the silicon nitride layer through-holes to form additional insulating film through-holes communicating with the trench; inserting tungsten metal into the additional insulating film through-holes and the trench;
depositing a metal layer on the second insulating film and the through-holes in the second insulating film, then etching the metal layer to expose the second insulating film, such that the upper surface of the metal layer within the through-holes in the second insulating film is lower than the upper surface of the second insulating film; a first passivation layer is deposited on the second insulating film and the metal layer; a second passivation layer is deposited on the first passivation layer, resulting in a semiconductor device having a termination region and passivation layers.

Exemplarily, the second insulating film, the first passivation layer, and the second passivation layer are all prepared using a PECVD deposition process.

In some embodiments, a semiconductor device having a termination region and a passivation layer, comprises: a substrate, the substrate comprising an upper surface and a lower surface, wherein the upper surface of the substrate is provided with a drift region of a first conductivity type; a first insulating film formed on the upper surface of the substrate; the upper surface of the substrate further includes a plurality of second-type protective rings, each of which extends into the drift region, with adjacent protective rings separated by the first insulating film, and the upper surfaces of the protective rings lying below the upper surface of the first insulating film; an additional insulating film is provided on the first insulating film and the protective rings; grooves are formed on each protective ring; the additional insulating film located above the protective rings is provided with through-holes communicating with the grooves; Tungsten metal is inserted into the through-holes of the additional insulating film and the grooves; a silicon nitride layer is provided on the additional insulating film and the additional insulating film through-holes; a second insulating film is provided on the silicon nitride layer; the second insulating film located above the protective rings is provided with second insulating film through-holes that correspond one-to-one with the silicon nitride layer; the angle between the inner wall of the second insulating film through-hole and the upper surface of the substrate is an acute angle; a first passivation layer is formed on the second insulating film and the second insulating film through-holes, with the lower surface of the first passivation layer lying below the lower surface of the second insulating film; a second passivation layer is formed on the first passivation layer.

Exemplarily, a conductive polycrystalline silicon layer is further provided between the additional insulating film and the protective ring.

Exemplarily, the acute angle is 30° or 70-80°; the thickness of the metal layer is 1-8 µm, and the thickness of the second insulating film is greater than that of the metal layer.

Exemplarily, the second insulating film is made of phosphosilicate glass.

Exemplarily, the additional insulating film is made of borosilicate glass.

Exemplarily, the upper surface of each protective ring has one or more grooves.

Exemplarily, the first insulating film is made of silicon dioxide; the first passivation layer is made of silicon-rich nitride (SiNx); the second passivation layer is made of polyimide; the metal is Al, AlCu, or AlSiCu.

In some embodiments, a method for preparing a semiconductor device based on any one of the above-mentioned devices having a termination region and a passivation layer, comprises the following steps: oxidizing the substrate, thermally growing and forming a first insulating film, etching the first insulating film to form a first etching trench, a first etched trench connected to the substrate; implanting boron ions into the first etched trench; forming protective rings on the substrate, with the upper surfaces of each protective ring lying below the upper surface of the first insulating film; and forming grooves on each protective ring; depositing an additional insulating film on the first insulating film and the protective rings; etching the additional insulating film to form through-holes in the additional insulating film above the protective rings that communicate with the grooves; inserting tungsten into the through-holes in the additional insulating film and the grooves; depositing a silicon nitride layer on the additional insulating film; depositing a second insulating film on the silicon nitride layer; etching through-holes in the second insulating film located above the protective rings, each corresponding to and communicating with a silicon nitride layer; the angle between the inner wall of the through-hole and the upper surface of the substrate is acute; depositing a first passivation layer on the second insulating film; a second passivation layer is formed on the first passivation layer, and the top surface of the second passivation layer is planarized, thereby obtaining a semiconductor device having a termination region and a passivation layer.

Exemplarily, the second insulating film, the first passivation layer, and the second passivation layer are all prepared using a PECVD deposition process.

Exemplarily, prior to depositing the additional insulating film, a conductive polysilicon layer is deposited on the first insulating film and the protective ring, followed by etching to partially expose the protective ring, after which the additional insulating film is deposited; the additional insulating film is etched to form through-holes in the additional insulating film that communicate with the trench or pass through the deposited additional insulating film, located above the protective ring.

The present invention provides a semiconductor device and manufacturing method with edge termination regions and passivation layers, which has the following improvements compared to the prior art:
1. The semiconductor device provided by the present invention has a termination region and a passivation layer. Each protective ring is separated by a first insulating film, and a thicker second insulating film is prepared on the first insulating film. The thicker second insulating film is deposited on the first insulating film. By forming a second insulation film through-hole connected to the protective ring on the second insulation film, completely depositing metal in the through-hole to form a metal layer, which contacts the protective ring, a metal layer having a plug structure is formed. The cross-section of the through-hole of the second insulating film is inverted trapezoidal, and the upper end surface of the metal layer is lower than that of the second insulating film. The metal layer no longer protrudes. After depositing the first passivation layer, it can make the first passivation layer flatter, without sharp angles or cracking, providing very stable moisture resistance and chemical corrosion resistance. The first passivation layer has very small mechanical stress and generates weak electrical coupling with the metal layer. The second passivation layer can prevent mechanical damage and solid particle pollution.
2. The semiconductor device provided by the present invention has a termination region and a passivation layer. The size and etching angle of the second insulating film through-hole determine how many metal is retained above the protective ring, which contributes to the electrical performance of the termination. Forming the metal layer into a plug form does not bring the disadvantage of additional topological structure in the termination where the first passivation layer is broken.
3. The semiconductor device provided by the present invention has a termination region and a passivation layer. The metal layer is made of Al, AlCu, or AlSiC, and the metal layer usually needs to be made of an adhesive material, such as Al, AlCu, AlSiCu, or similar materials. The metal cannot be too hard, and during operation, the chip with the metal will be heated and cooled. The thermal expansion coefficients of silicon and metal are different. If a hard metal is selected, it may damage the semiconductor.
4. The semiconductor device provided by the present invention has a termination region and a passivation layer. In an embodiment, the metal layer is omitted and the easily corroded metal layer is removed. The metal layer is usually the weak current of the terminal in terms of humidity robustness, which helps to block the smooth electric field during the process. Metal tungsten may be connected to the protective ring, and the first passivation layer is connected to the metal tungsten. The lower end surface of the first passivation layer 7 is lower than the lower end surface of the second insulating film 5, which provides better shielding for high electric fields.

### BRIEF DESCRIPTION OF THE DRAWINGS

In order to provide a clearer explanation of the specific embodiments of the present invention or the technical solutions in the prior art, a brief introduction will be given to the accompanying drawings required for the description of the specific embodiments or the prior art. It is obvious that the accompanying drawings described below are some embodiments of the present invention. For those skilled in the art, other drawings can be obtained based on these drawings without creative labor.
Figure 1 is a schematic diagram (top view) of an existing power semiconductor chip;
Figure 2 is a sectional view of Figure 1; The cross-section of the existing termination area has multiple p+diffusion protection rings, which are separated by local silicon oxidation and contacted by floating metal plugs. The metal is passivated by silicon rich nitride (SRN) and polyimide films.
Figure 3 is a schematic diagram of the structure of the termination area in the prior art. Multiple p+diffusion protection rings are separated by local silicon oxidation and are weakly coupled to each other through metal contacts. The metal plugs are then passivated by a silicon nitride layer and a polyimide film through a semi insulating layer.
Figure 4 is an enlarged view of Figure 3; If the angle α or β of the cross-section of the metal structure is too small, the silicon nitride film may crack, as shown in a typical example in the figure on the right.
Figure 5 shows the preparation process diagram (1) of a semiconductor device with a termination region and a passivation layer in Example 1;
Figure 6 shows the preparation process diagram (2) of a semiconductor device with a termination region and a passivation layer in Example 1;
Figure 7 shows the preparation process diagram (III) of a semiconductor device with a termination region and a passivation layer in Example 1;
Figure 8 shows the preparation process diagram (4) of a semiconductor device with a termination region and a passivation layer in Example 1;
Figure 9 shows the preparation process diagram (1) of a semiconductor device with a termination region and a passivation layer in Example 2;

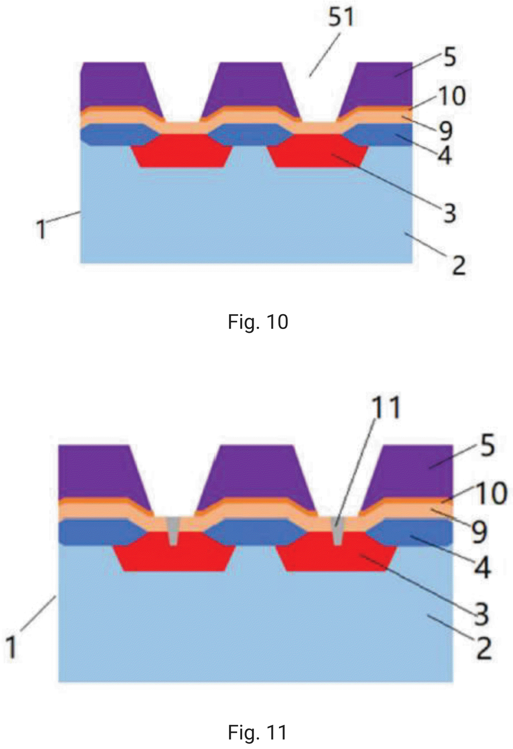

Figure 10 shows the preparation process diagram (2) of a semiconductor device with a termination region and a passivation layer in Example 2;
Figure 11 shows the preparation process diagram (III) of a semiconductor device with a termination region and a passivation layer in Example 2;

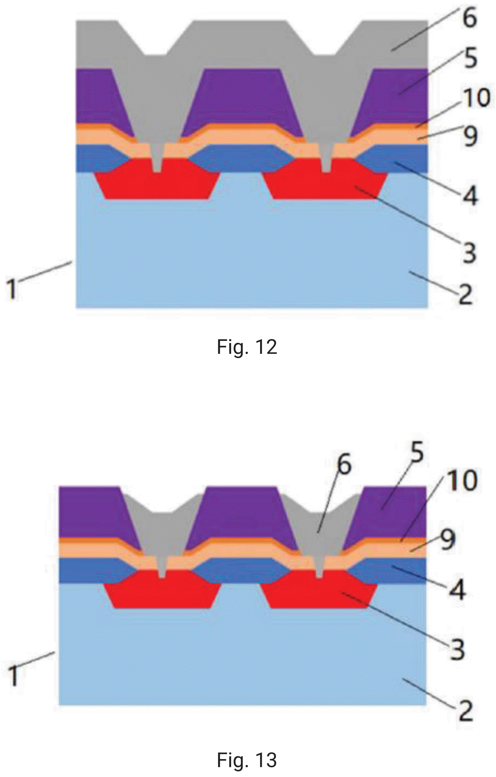

Figure 12 shows the preparation process diagram (4) of a semiconductor device with a termination region and a passivation layer in Example 2;
Figure 13 shows the preparation process diagram (5) of a semiconductor device with a termination region and a passivation layer in Example 2;
Figure 14 shows the preparation process diagram (VI) of a semiconductor device with a termination region and a passivation layer in Example 2;
Figure 15 is a schematic diagram of the semiconductor device structure with a termination region and a passivation layer obtained in Example 3;
Figure 16 is a schematic diagram of the semiconductor device structure with a termination region and a passivation layer obtained in Example 4;

Annotations on the accompanying drawings:
1. Substrate; 2. Drift zone; 3. Protective ring; 4. First insulation film; 5. Second insulation film; 51. Second insulation film through-hole; 6. Metal layer; 7. The first passivation layer; 8. Second passivation layer; 9. Additional insulation film; 10. Silicon nitride layer; 11. Metal tungsten; 12. Conductive polycrystalline silicon layer.

### DESCRIPTION OF DETAILED EMBODIMENTS

The following will provide a clear and complete description of the technical solution of the present invention in conjunction with the accompanying drawings. Obviously, the described embodiments are only a part of the embodiments of the present invention, not all of them. Based on the embodiments of the present invention, all other embodiments obtained by ordinary skilled persons in the art without creative labor are within the scope of protection of the present invention.

In the description of the present invention, it should be noted that the terms "center", "up", "down", "left", "right", "vertical", "horizontal", "inside", "outside" and other directional or positional relationships indicated are based on the directional or positional relationships shown in the accompanying drawings, only for the convenience of describing the present invention and simplifying the description, and do not indicate or imply that the device or element referred to must have a specific orientation, be constructed and operated in a specific orientation, and therefore cannot be understood as a limitation of the present invention. In addition, the terms "first", "second", and "third" are only used for descriptive purposes and cannot be understood as indicating or implying relative importance.

In the description of the present invention, it should be noted that unless otherwise specified and limited, the terms "installation", "connection", and "connection" should be broadly understood, for example, they can be fixed connections, detachable connections, or integral connections; It can be a mechanical connection or an electrical connection; It can be directly connected, indirectly connected through an intermediate medium, or connected internally between two components. For ordinary technical personnel in this field, the specific meanings of the above terms in the present invention can be understood in specific situations.

### Example 1

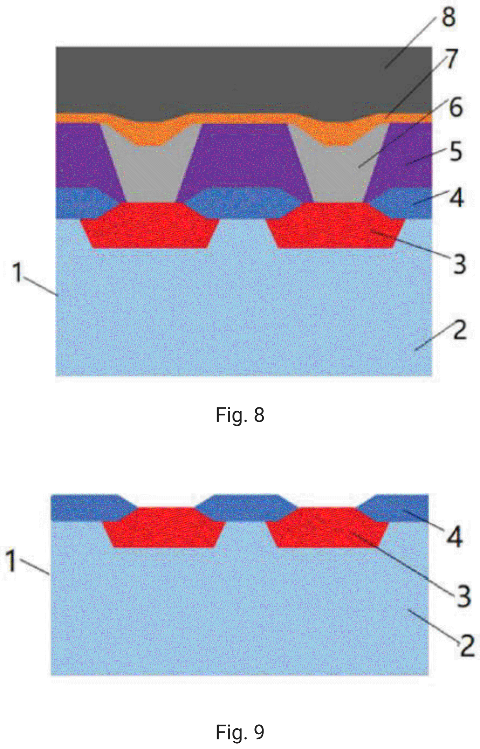

As shown in Figure 8, this embodiment provides a semiconductor device with a termination region and a passivation layer, which includes a substrate 1. The substrate 1 includes an upper end face and a lower end face, wherein the upper end face of the substrate 1 is provided with a drift region 2 of a first conductivity type (e.g. n-type conductivity). A first insulating film 4 is provided on the upper end face of substrate 1. The upper end face of substrate 1 is also provided with multiple second conductive type protective rings (guard rings) 3, each protective ring 3 penetrating into the drift region 2. Adjacent protective rings 3 are separated by a first insulating film 4, and the upper end face of each protective ring 3 is lower than the upper end face of the first insulating film 4. A second insulation film 5 is provided on the first insulation film 4 and the protective ring 3, and a second insulation film through-hole 51 is provided on the second insulation film 5 to correspond with each protective ring 3. The inner wall of each second insulation film through-hole 51 forms an acute angle with the upper end surface of the substrate 1 (the acute angle is formed outside of the through-hole similar to the angle β shown in Figure 4a). Each second insulating film through-hole 51 is provided with a metal layer 6, and the upper end surface of the metal layer 6 located in the second insulating film through-hole 51 is lower than the upper end surface of the second insulating film 5. A first passivation layer 7 is provided on the second insulating film 5 and the metal layer 6. A second passivation layer 8 is provided on top of the first passivation layer 7.

The present invention proposes a semiconductor device with a termination region and a passivation layer. Each protective ring is separated by a first insulating film 4, and a thicker second insulating film 5 is prepared on the first insulating film 4. The thicker second insulating film is deposited on the first insulating film 4. A second insulation film through-hole 51 is opened on the second insulation film 5, which is connected to the protective ring. The metal is completely deposited in the through-hole, forming a metal layer. The metal layer contacts the protective ring, forming a plug-like structure. The cross-section of the second insulation film through-hole 51 is inverted trapezoidal, and the upper end surface of the metal layer 6 is lower than the upper end surface of the second insulation film 5. The metal layer no longer protrudes. After depositing the first passivation layer, it can make the first passivation layer flatter, without sharp angles or cracking, providing very stable moisture resistance and chemical corrosion resistance. The first passivation layer has very small mechanical stress, generating weak electrical coupling between it and the metal layer 6. The second passivation layer can prevent mechanical damage and solid particle pollution.

Furthermore, the size and etching angle of the second insulating film through-hole 51 determine how many metal material is retained above the protective rings, which contributes to the electrical performance of the termination. Forming the metal layer into a plug form does not bring the disadvantage of additional topological structure in the termination where the first passivation layer is broken.

The function of the metal layer of the present invention is to redirect the electric field under reverse bias into the field oxide. The critical electric field of the field oxide is several orders of magnitude higher than that of the semiconductor, which means that a well-designed metal plate can help achieve a more compact terminal structure with excellent moisture resistance.

The acute angle of this embodiment is 30° or 70-80 °. The thickness of the metal layer (6) is 1-8 µm, and the thickness of the second insulating film 5 is greater than that of the metal layer 6.

The etching of the second insulating film through-hole in the present embodiment can be carried out by wet etching or dry etching. The angle generated by wet etching is 30°, and the angle generated by dry etching is 70-80°. The etching method and angle can be selected according to the needs.

The thickness of the second insulating film 5 of the present embodiment should be ensured within the set range to ensure the deposition of metal. The thickness of the second insulating film 5 should be greater than that of the metal layer 6, but it should not be too thick. The horizontal size of the clusters should not be very fine and should be maintained within a certain range, determined according to the thickness of the metal layer 6.

The material of the second insulating film 5 of the present invention is phosphosilicate glass, which has strong insulation and chemical inertness, and will not be subjected to stress in the terminal structure. At the same time, it can deposit quickly and help remove impurities from the silicon surface by suction. The first insulating film 4 of the present invention uses field oxide (FOX), which is a strong insulating dielectric material, typically thermally grown silicon dioxide.

The first passivation layer material of the present embodiment is silicon rich nitride (SiNx).

The second passivation layer material of the present embodiment is a polymer, which is polyimide.

The material of the metal layer 6 in the present embodiment is Al, AlCu, or AlSiC. The metal layer usually needs to be made of adhesive materials such as Al, AlCu, AlSiCu, or similar materials. The metal cannot be too hard, and during operation, the chip with metal will be heated and cooled. The thermal expansion coefficients of silicon and metal are different. If hard metal is chosen, it may damage the semiconductor.

The substrate 1 of the present embodiment is a silicon wafer.

The thickness of the first passivation layer of the present embodiment is greater than 100nm, with a preferred range of 0.5-3 µm.

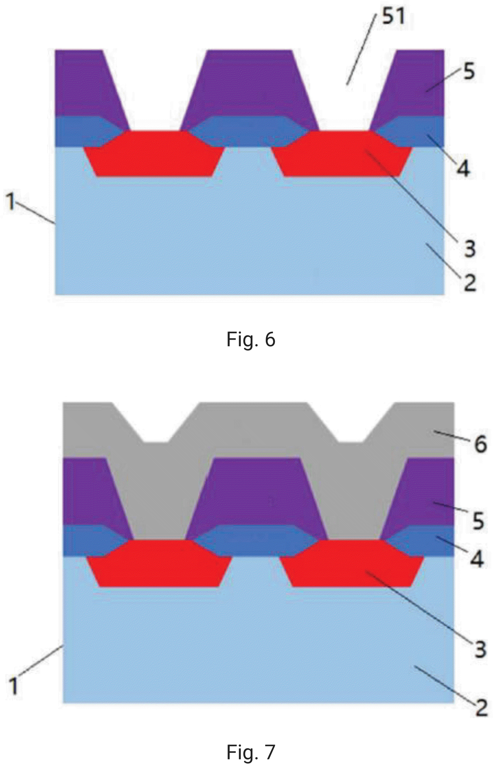

As shown in Figures 5, 6, 7, and 8, this embodiment also provides a method for preparing a semiconductor device with a termination region and a passivation layer based on any of the above, comprising the following steps 101 to 105:
101) Oxidation treatment is performed on substrate 1, followed by thermal growth to form a first insulating film 4. The first insulating film 4 is then etched to form a first etching groove connected to substrate 1. Boron ions are implanted into the first etching groove to form protective rings 3 on substrate 1, with the upper end faces of each protective ring 3 being lower than the upper end face of the first insulating film 4.
102) A second insulating film 5 is deposited on the first insulating film 4 and the protective ring 3. The second insulating film 5 is patterned, etched, and a second insulating film through-hole 51 is formed on the second insulating film 5, which corresponds one-to-one with each protective ring 3. The inner wall of each second insulating film through-hole 51 forms an acute angle with the upper end face of the substrate 1.
103) Deposition of metal on the second insulating film 5 and the second insulating film through-hole 51 to form a metal layer 6, etching of the metal layer 6 to expose the second insulating film 5. The upper end surface of the metal layer 6 located within the second insulating film through-hole 51 is lower than the upper end surface of the second insulating film 5.
104) A first passivation layer 7 is deposited on the second insulating film 5 and the metal layer 6.
105) A second passivation layer 8 is deposited on the first passivation layer 7 to obtain a semiconductor device with a terminal region and a passivation layer.

The patterning and etching steps of the second insulating film 5 of the present embodiment are the most critical steps in achieving the desired structure. The size and etching angle of the second insulating film through-hole 51 determine how many metal plug material is retained above the P-ring, and metal deposition and etching are completed without any patterning or etching masks, thereby simplifying the process.

In order to preserve the amount of metal in the through-hole, the thickness of metal deposition in the present embodiment needs to be greater than the height of the second insulating film through-hole 51 to ensure complete filling of the second insulating film through-hole 51. The metal deposition method requires a suitable material with strong surface adhesion to provide sufficient protective coating on the contour. Chemical vapor deposition (CVD) or cycling between less conformal deposition (sputtering) and etching can be used to achieve uniform coating.

The second insulating film 5, the first passivation layer 7, and the second passivation layer 8 of the present embodiment are all prepared using PECVD deposition process.

### Example 2

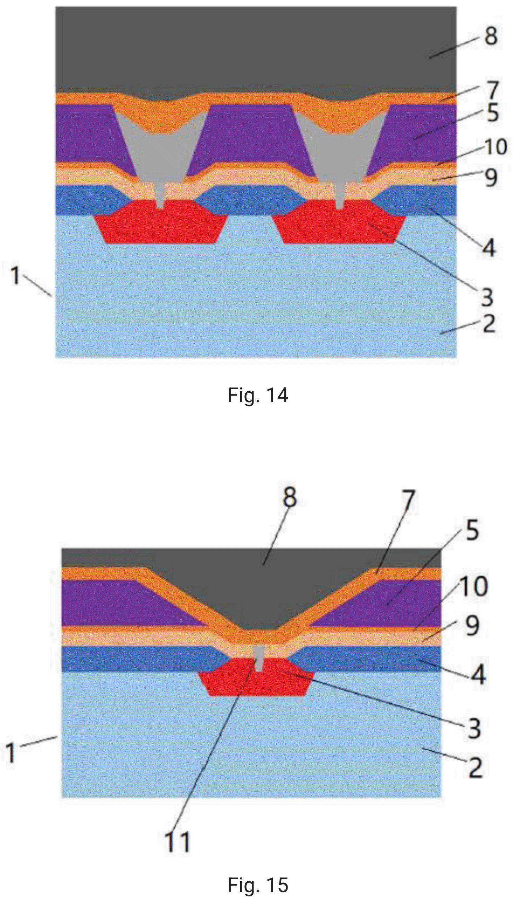

As shown in Figure 14, this embodiment provides a semiconductor device with a termination region and a passivation layer, which includes a substrate 1. The substrate 1 includes an upper end face and a lower end face, and the upper end face of the substrate 1 is provided with a drift region 2 of the first conductivity type; A first insulating film 4 is provided on the upper end face of substrate 1; The upper end face of substrate 1 is also provided with multiple second conductive type protective rings 3, each protective ring 3 penetrating into the drift region 2. Adjacent protective rings 3 are separated by a first insulating film 4, and the upper end face of each protective ring 3 is lower than the upper end face of the first insulating film 4. An additional insulating film 9 is provided on the first insulating film 4 and the protective ring 3. A silicon nitride layer 10 is provided on the additional insulating film 9. A second insulating film 5 is provided on the silicon nitride layer 10. Each protective ring 3 is equipped with a groove. The second insulating film 5 located above the protective ring is provided with a second insulating film through-hole 51 that corresponds one-to-one with the silicon nitride layer 10. The angle between the inner wall of the second insulating film through-hole 51 and the upper end face of the substrate 1 is an acute angle (at an outer side of the through-hole similar to the angle β in Figure 4a, wherein for the purpose of determining the angle, an averaged upper end face of the substrate may be used, defined by the mean height level of the uneven upper end face). The silicon nitride layer 10 located above the protective ring is provided with a silicon nitride layer through-hole connected to the additional insulating film 9. The angle between the inner wall of the silicon nitride layer through-hole and the upper end face of the substrate 1 is 30° or 70-80°. On the additional insulation film 9 located above the protective ring 3, there is an additional insulation film through-hole connected to the groove. The second insulation film through-hole 51, the silicon nitride layer through-hole, the additional insulation film through-hole, and the groove are coaxially arranged. Metal tungsten 11 is inserted into the through holes and grooves of the additional insulation film. A metal layer 6 is provided inside the through holes 51 of the silicon nitride layer and the second insulating film, and the upper end surface of the metal layer 6 is lower than the upper end surface of the second insulating film 5. A first passivation layer 7 is provided on the second insulating film 5, and a second passivation layer 8 is provided on the first passivation layer 7.

The present embodiment proposes a semiconductor device with a termination region and a passivation layer. Each protective ring is separated by a first insulating film 4, and an additional insulating film 9 and a thinner silicon nitride layer 10 are deposited on the first insulating film 4. A thicker second insulating film is deposited on the silicon nitride layer 10; The second insulating film through-hole 51, the silicon nitride layer through-hole, the additional insulating film through-hole, and the trench are coaxially arranged. Metal tungsten 11 is inserted into the through holes and grooves of the additional insulation film. A metal layer 6 is provided inside the through holes of the silicon nitride layer and the second insulating film 51. The cross-section of the second insulating film through hole 51 is trapezoidal, and the upper end surface of the metal layer 6 is lower than the upper end surface of the second insulating film 5. The metal layer no longer protrudes. After depositing the first passivation layer, it can make the first passivation layer flatter, without sharp angles or cracking, providing very stable moisture resistance and chemical corrosion resistance. The first passivation layer has very small mechanical stress, which generates weak electrical coupling with the metal layer 6. The second passivation layer can prevent mechanical damage and solid particle pollution.

The additional insulation film 9 and thinner silicon nitride layer 10 are not strictly required at the terminal, but are strictly required at the active, gate, and emitter of IGBT. The additional insulation film 9 and thinner silicon nitride layer 10 can be retained at the terminal to save photolithography steps and masks. The silicon nitride layer 10 can be deposited at the lower end of the second insulation layer 5 as a stop layer for etching _{∘}

Due to the additional insulation film 9, the present embodiment requires the use of tungsten metal to be inserted into the additional insulation film 9 and in contact with the protective ring. Tungsten metal forms a very strong contact with silicon and has strong chemical inertness.

The acute angle of the present embodiment is 30° or 70-80°; The thickness of the metal layer 6 is 1-8 µm, and the thickness of the second insulating film 5 is greater than that of the metal layer 6. The material of the second insulating film 5 of the present embodiment is phosphosilicate glass. The material of the additional insulating film 9 of the present embodiment is borophosphosilicate glass. Each protective ring 3 of the present embodiment has one or more grooves on its upper end face. The material of the first insulating film 4 of the present embodiment is silicon dioxide. The material of the first passivation layer is silicon rich nitride (SiNx). The material of the second passivation layer is polymer. The metal layer material is Al, AlCu or AlSiCu. The polymer is polyimide.

The present embodiment also provides a method for preparing a semiconductor device with a termination region and a passivation layer based on any one of the above, characterized in that it comprises the following steps 201 to 211:
201) Oxidation treatment is performed on substrate 1, followed by thermal growth to form a first insulating film 4. The first insulating film 4 is then etched to form a first etching groove connected to substrate 1. Boron ions are implanted into the first etching groove to form protective rings 3 on substrate 1. The upper end faces of each protective ring 3 are lower than those of the first insulating film 4, and grooves are opened on each protective ring 3.
202) Deposition of additional insulation film 9 on the first insulation film 4 and the protective ring 3.
203) Deposition of a silicon nitride layer 10 on the additional insulating film 9.
204) Depositing a second insulating film 5 on the silicon nitride layer 10.
205) The second insulating film 5 is patterned and etched to form second insulating film through holes 51 on the second insulating film 5 located above the protective ring 3, which correspond one-to-one with the silicon nitride layer 10. The inner walls of each second insulating film through hole 51 form an acute angle with the upper end face of the substrate 1.
206) Etching the silicon nitride layer 10 below the second insulating film through-hole 51 to form a silicon nitride layer through-hole connected to the additional insulating film 9. The angle between the inner wall of the silicon nitride layer through-hole and the upper end surface of the substrate 1 is the same as the angle between the inner wall of the second insulating film through-hole 51 and the upper end surface of the substrate 1.
207) Etching the additional insulating film 9 from the through hole of the silicon nitride layer to form an additional insulating film through hole connected to the trench.
208) Inserting metal tungsten 11 into the through holes and grooves of the additional insulation film; 209) Deposition of metal on the second insulating film 5 and the second insulating film through-hole 51 to form a metal layer 6, etching of the metal layer 6 to expose the second insulating film 5. The upper end surface of the metal layer 6 located within the second insulating film through-hole 51 is lower than the upper end surface of the second insulating film 5.
210) A first passivation layer 7 is deposited on the second insulating film 5 and the metal layer 6.
211) A second passivation layer 8 is deposited on the first passivation layer 7 to obtain a semiconductor device with a termination region and a passivation layer.

The second insulating film 5, the first passivation layer 7, and the second passivation layer 8 in this embodiment are all prepared using PECVD deposition process.

### Example 3

The present embodiment also provides a semiconductor device with a termination region and a passivation layer, comprising a substrate 1, wherein the substrate 1 comprises an upper end face and a lower end face, and the upper end face of the substrate 1 is provided with a drift region 2 of a first conductivity type. A first insulating film 4 is provided on the upper end face of substrate 1. The upper end face of substrate 1 is also provided with multiple second conductive type protective rings 3, each protective ring 3 penetrating into the drift region 2. Adjacent protective rings 3 are separated by a first insulating film 4, and the upper end face of each protective ring 3 is lower than the upper end face of the first insulating film 4. An additional insulating film 9 is provided on the first insulating film 4 and the protective ring 3. Each protective ring 3 is equipped with grooves. An additional insulation film through-hole connected to the groove is provided on the additional insulation film 9 located above the protective ring 3. Metal tungsten 11 is inserted into the through holes and grooves of the additional insulation film. The additional insulation film 9 and the additional insulation film through-hole are provided with a silicon nitride layer 10. A second insulating film 5 is provided on the silicon nitride layer 10. The second insulating film 5 located above the protective ring 3 is provided with a second insulating film through-hole 51 that corresponds one-to-one with the silicon nitride layer 10. The angle between the inner wall of the second insulating film through-hole 51 and the upper end face of the substrate 1 is an acute angle. A first passivation layer 7 is formed on the second insulating film 5 and the second insulating film through-hole 51, and the lower end surface of the first passivation layer 7 is lower than the lower end surface of the second insulating film 5. There is also formed a second passivation layer 8 on top of the first passivation layer 7.

This embodiment omits the metal layer and removes the easily corroded metal layer. The metal layer is usually weak in terms of humidity robustness at the terminal, which helps to block smooth electric fields during the process. Using metal tungsten and protective ring connection, the first passivation layer is connected to metal tungsten, and the lower end surface of the first passivation layer 7 is lower than the lower end surface of the second insulating film 5, which provides better shielding for high electric fields. Compared to Examples 1 and 2, this example eliminates the easily corrodible metal layer, which is typically a weak point in terms of humidity robustness. Tungsten 11 is used to connect to the protective ring 3, and the first passivation layer 7 is connected to the tungsten 11. Since the lower surface of the first passivation layer 7 is lower than the lower surface of the second insulating film 5, it provides better shielding against high electric fields.Furthermore, compared to materials such as Al, AlCu, or AlSiCu, tungsten offers higher hardness and better inertness for applications like forming connectors, and it forms an excellent ohmic contact with silicon.

Aluminum-based metals are used as the top-layer metal because they need to be sufficiently soft to withstand mechanical stress without damaging the chip. However, due to factors such as chemical reactivity and limited thermal stability, the metal itself is not ideal. Compared to aluminum-based metals tungsten is a better choice for the layer in contact with silicon.

The acute angle of this embodiment is 30° or 70-80°. The thickness of the metal layer 6 is 1-8 µm, and the thickness of the second insulating film 5 is greater than that of the metal layer 6.

The material of the second insulating film 5 in this embodiment is phosphosilicate glass.

The material of the additional insulating film 9 in this embodiment is borophosphosilicate glass.

Each protective ring 3 in this embodiment has one or more grooves on its upper end face.

The material of the first insulating film 4 in this embodiment is silicon dioxide;

The material of the first passivation layer is silicon rich nitride (SiNx). The material of the second passivation layer is polyimide. The metal is Al, AlCu or AlSiCu.

This embodiment also provides a method for manufacturing a semiconductor device based on any one of the above described devices having a termination region and a passivation layer, comprising the following steps 301 to 309:
301) Oxidation treatment is performed on substrate 1, followed by thermal growth to form a first insulating film 4. The first insulating film 4 is then etched to form a first etching groove connected to substrate 1. Boron ions are implanted into the first etching groove to form protective rings 3 on substrate 1. The upper end faces of each protective ring 3 are lower than those of the first insulating film 4, and grooves are opened on each protective ring 3.
302) Deposition of additional insulation film 9 on the first insulation film 4 and the protective ring 3.
303) Etching the additional insulation film 9 to form an additional insulation film through-hole connected to the trench on the additional insulation film 9 located above the protective ring 3.
304) Inserting metal tungsten 11 into the through holes and grooves of the additional insulation film.
305) Deposition of a silicon nitride layer 10 on the additional insulating film 9.
306) Depositing a second insulating film 5 on the silicon nitride layer 10.
307) Etching a second insulating film through-hole 51 on the second insulating film 5 located above the protective ring 3, which corresponds one-to-one with the silicon nitride layer 10. The angle between the inner wall of the second insulating film through-hole 51 and the upper end face of the substrate 1 is an acute angle.
308) Deposition of a first passivation layer 7 on the second insulating film 5.
309) A second passivation layer 8 is provided on the first passivation layer 7, and the upper end face of the second passivation layer 8 is flattened to obtain a semiconductor device with a terminal region and a passivation layer.

The second insulating film 5, the first passivation layer 7, and the second passivation layer 8 of the present embodiment are all prepared using PECVD deposition process.

### Example 4

This embodiment is a further improvement based on the embodiment described above in Example 3. The only difference from embodiment above in Example 3 is that a conductive polycrystalline silicon layer 12 is also provided between the additional insulating film 9 and the protective ring 3.

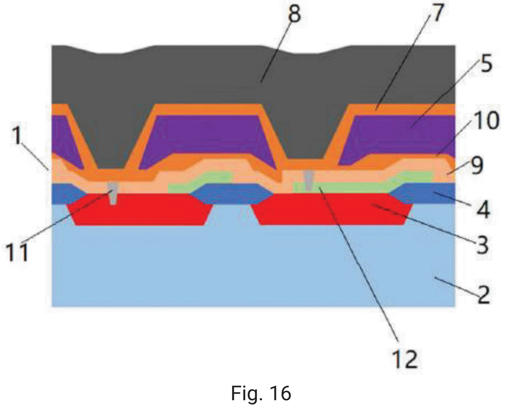

As shown in Figure 16, before depositing the additional insulating film 9, a conductive polycrystalline silicon layer 12 is deposited on the first insulating film 14 and the protective ring 3, etched to expose part of the protective ring 3, and then the additional insulating film 9 is deposited; and the additional insulation film 9 is etched to form additional insulation film through holes connected to the trench or through holes connected to the deposited additional insulation film 9 on the additional insulation film 9 located above the protective ring 3.

This embodiment replaces metal with a conductive polycrystalline silicon layer 12, which is chemically very stable and not as thick as a metal layer. It can maintain a smooth electric field and remove corrosive elements from the terminal.

Finally, it should be noted that the above embodiments are only used to illustrate the technical solution of the present embodiment, and not to limit it. Although the present embodiment has been described in detail with reference to the aforementioned embodiments, those skilled in the art should understand that they can still modify the technical solutions described in the aforementioned embodiments, or equivalently replace some or all of the technical features; And these modifications or substitutions do not deviate from the essence of the corresponding technical solutions from the scope of the various embodiments of the present invention.

## Claims

1. A semiconductor device with a termination region and a passivation layer, the semiconductor device comprising:
a substrate (1) comprising an upper end face and a lower end face, wherein the upper end face of the substrate (1) is provided with a drift region (2) of a first conductivity type;
a plurality of protective rings (3) of a second conductivity type formed in the upper end face of the substrate (1), each protective ring (3) penetrating into the drift region (2),
a first insulating film (4) provided on the upper end face of the substrate (1), wherein adjacent protective rings (3) are separated by the first insulating film (4), and wherein an upper end face of each protective ring (3) is lower than an upper end face of the first insulating film (4),
a second insulating film (5) arranged on the first insulating film (4) and the plurality of protective rings (3), the second insulating film (5) comprising a plurality of second insulating film through holes (51) in one-to-one correspondence with the plurality of protective rings (3), wherein an inner wall of each second insulating film through hole (51) forms an acute angle with the upper end face of the substrate (1);
a metal layer (6) in each second insulating film through-hole (51), wherein an upper end surface of the metal layer (6) located in each second insulating film through-hole (51) is lower than an upper end surface of the second insulating film (5);
a first passivation layer (7) arranged on the second insulating film (5) and the metal layer (6); and
a second passivation layer (8) arranged on top of the first passivation layer (7).

2. The semiconductor device according to claim 1, wherein:
the acute angle is 30° or 70°-80°,
a thickness of the metal layer (6) is 1 µm - 8 µm, and
a thickness of the second insulating film (5) is greater than that of the metal layer (6).

3. The semiconductor device according to any one of claims 1 or 2,
wherein each protective ring (3) comprises a groove;
wherein the semiconductor device further comprises:
an additional insulating film (9) provided on the first insulating film (4) and the plurality of protective rings (3), wherein the additional insulation film (9) comprises a plurality of additional insulation film through-holes in one-to-one correspondence with the plurality of protective rings (3), each additional insulation film through-hole being connected to a corresponding groove in a corresponding protective ring (3); and
a silicon nitride layer (10) provided on the additional insulating film (9), wherein the silicon nitride layer (10) comprises a plurality of silicon nitride layer through-holes connected to the additional insulating film (9) above each protective ring (3), and wherein an angle between an inner wall of each silicon nitride layer through-hole and the upper end face of the substrate (1) is 30° or 70°-80°;
wherein the second insulating film (5) is provided on the silicon nitride layer (10), wherein the plurality of second insulating film through-holes (51) are in one-to-one correspondence with the plurality of silicon nitride layer through-holes;
wherein each second insulating film through-hole (51) is coaxially arranged with a corresponding silicon nitride layer through-hole, a corresponding additional insulation film through-hole, and a corresponding groove in a correspond protective ring (3);
wherein a metal tungsten (11) is provided in each groove and in each additional insulation film through-hole; and
wherein the metal layer (6) is provided in each second insulating film through-hole (51) and in each silicon nitride layer through hole.

4. A semiconductor device with a termination region and a passivation layer, the semiconductor device comprising:
a substrate (1) comprising an upper end face and a lower end face, wherein the upper end face of the substrate (1) is provided with a drift region (2) of a first conductivity type;
a plurality of protective rings (3) of a second conductivity type formed in the upper end face of the substrate (1), each protective ring (3) penetrating into the drift region (2) and each protective ring (3) comprising a groove;
a first insulating film (4) provided on the upper end face of the substrate (1), wherein adjacent protective rings (3) are separated by the first insulating film (4), and wherein the upper end face of each protective ring (3) is lower than an upper end face of the first insulating film (4);
an additional insulating film (9) provided on the first insulating film (4) and the plurality of protective rings (3), wherein the additional insulating film (9) comprises a plurality of additional insulation film through-holes in one-to-one correspondence with the plurality of protective rings (3), each additional insulation film through-hole being connected to a corresponding groove in a corresponding protective ring (3);
metal tungsten (11) provided in each groove and in each additional insulation film through-hole;
an additional insulating film (9) and a silicon nitride layer (10) provided on the additional insulating film (9);
a second insulating film (5) provided on the silicon nitride layer (10) and located above the plurality of protective rings (3), wherein the second insulating film (5) comprises a plurality of second insulating film through-holes (51) in one-to-one correspondence with the plurality of protective rings (3), wherein an inner wall of each second insulating film through hole (51) forms an acute angle with the upper end face of the substrate (1);
a first passivation layer (7) provided on the second insulating film (5) and the plurality of second insulating film through-holes (51), wherein a lower end surface of the first passivation layer (7) is lower than a lower end surface of the second insulating film (5);
a second passivation layer (8) provided on top of the first passivation layer (7).

5. The semiconductor device according to claim 4, wherein a conductive polycrystalline silicon layer (12) is also provided between the additional insulating film (9) and the protective ring (3).

6. The semiconductor device according to any one of claims 3 to 5, wherein the material of the additional insulating film (9) is borophosphosilicate glass.

7. A method for preparing a semiconductor device with a termination region and a passivation layer as claimed in any one of claims 1 or 2, wherein the method comprises the following steps:
performing an oxidation treatment on the substrate (1), followed by thermal growth to form a first insulating film (4);
etching the first insulating film (4) to form a first etching groove connected to the substrate (1);
implanting boron ions into the first etching groove to form a plurality of protective rings (3) on the substrate (1), wherein an upper end face of each protective ring (3) is lower than an upper end face of the first insulating film (4);
depositing a second insulating film (5) on the first insulating film (4) and the plurality of protective rings (3);
patterning and etching the second insulating film (5) to form a plurality of second insulating film through holes (51) in the second insulating film (5), the plurality of second insulating film through holes (51) being in one-to-one correspondence with the plurality of protective rings (3), wherein an inner wall of each second insulating film through hole (51) forms an acute angle with an upper end face of the substrate (1);
depositing a metal on the second insulating film (5) and in each second insulating film through-hole (51) to form a metal layer (6), etching of the metal layer (6) to expose the second insulating film (5), with an upper end face of the metal layer (6) located within each second insulating film through-hole (51) being lower than an upper end face of the second insulating film (5);
depositing a first passivation layer (7) on the second insulating film (5) and the metal layer (6);
depositing a second passivation layer (8) on the first passivation layer (7) to obtain the semiconductor device with the termination region and the passivation layer.

8. A method for preparing a semiconductor device with a termination region and a passivation layer as claimed in claim 3, the method comprising the following steps:
performing an oxidation treatment and thermal growth on the substrate (1) to form a first insulating film (4);
etching the first insulating film (4) to form a first etching groove connected to the substrate (1);
implanting boron ions into the first etching groove to form a protective ring (3) on the substrate (1),
wherein the upper end surface of each protective ring (3) is lower than the upper end surface of the first insulating film (4), and grooves are opened on each protective ring (3);
depositing an additional insulating film (9) on the first insulating film (4) and the protective ring (3);
depositing a silicon nitride layer (10) on the additional insulating film (9);
depositing a second insulating film (5) on the silicon nitride layer (10);
patterning and etching the second insulating film (5) to form second insulating film through holes (51) in one-to-one correspondence with the silicon nitride layer (10) on the second insulating film (5) located above the protective rings (3), and wherein the inner wall of each second insulating film through hole (51) is at an acute angle with the upper end surface of the substrate (1);
etching the silicon nitride layer (10) below each second insulating film through-hole (51) to form a plurality of silicon nitride layer through-holes connected to the additional insulating film (9), wherein the angle between the inner wall of each silicon nitride layer through-hole and the upper end surface of the substrate (1) is the same as an angle between the inner wall of a corresponding second insulating film through-hole (51) and the upper end surface of the substrate (1);
etching the additional insulating film (9) from the through hole of the silicon nitride layer to form an additional insulating film through hole connected to the trench;
inserting metal tungsten (11) into the through holes and grooves of the additional insulation film;
depositing metal on the second insulating film (5) and the second insulating film through-hole (51) to form a metal layer (6), and etching the metal layer (6) to expose the second insulating film (5), wherein an upper end face of the metal layer (6) located within the second insulating film through-hole (51) is lower than the upper end face of the second insulating film (5);
depositing a first passivation layer (7) on the second insulating film (5) and the metal layer (6);
depositing a second passivation layer (8) on the first passivation layer (7) to obtain a semiconductor device with a terminal region and a passivation layer.

9. A method for preparing a semiconductor device as claimed in claim 4 or 5, wherein the method comprises the following steps:
performing oxidation treatment and thermal growth on the substrate (1) to form a first insulating film (4);
etching the first insulating film (4) to form a first etching grooves connected to the substrate (1);
implanting boron ions into the first etching grooves to form a plurality of protective rings (3) on the substrate (1), wherein the upper end surface of each protective ring (3) is lower than the upper end surface of the first insulating film (4), and wherein a groove is opened on each protective ring (3);
depositing an additional insulating film (9) on the first insulating film (4) and the protective rings (3);
etching the additional insulation film (9) to form a plurality of additional insulation film through-holes connected to each groove in the plurality of protective rings (3);
inserting metal tungsten (11) into the grooves and the additional insulation film through holes;
depositing a silicon nitride layer (10) on the additional insulating film (9);
depositing a second insulating film (5) on the silicon nitride layer (10);
etching the second insulating film (5) to form a plurality of second insulating film through-holes (51) in one-to-one correspondence with the protective rings (3), wherein an inner wall of each second insulating film through hole (51) forms an acute angle with the upper end face of the substrate (1);
depositing a first passivation layer (7) on the second insulating film (5);
depositing second passivation layer (8) on the first passivation layer (7); and
flattening the upper end face of the second passivation layer (8) to obtain the semiconductor device.

10. The method according to claim 9, wherein:
before depositing the additional insulating film (9), a conductive polycrystalline silicon layer (12) is deposited on the first insulating film (4) and the protective rings (3), etched to expose parts of the protective rings (3), and then the additional insulating film (9) is deposited;
the additional insulation film (9) is etched to form the additional insulation film through holes connected to the trench or through holes connected to the deposited additional insulation film (9) on the additional insulation film (9) located above the protective rings (3).

11. The method according to any one of claims 7 to 10, wherein the second insulating film (5), the first passivation layer (7), and the second passivation layer (8) are all prepared by PECVD deposition process.

12. The semiconductor device or the method according to any one of the preceding claims, wherein:
the material of the first insulating film (4) is silicon dioxide;
the material of the first passivation layer is silicon rich nitride (SiNx);
the material of the second passivation layer is polymer;
the material of the metal layer (6) is Al, AlCu or AlSiC.

13. The semiconductor device or the method according to claim 12, wherein the polymer is polyimide, and/or wherein the substrate is a silicon wafer.

14. The semiconductor device or the method according to any one of the preceding claims, wherein the acute angle is 30 ° or 70-80°.

15. The semiconductor device or the method according to any one of the preceding claims, wherein the material of the second insulating film (5) is phosphosilicate glass, and/or wherein the substrate (1) is a silicon wafer.
